# DEMANDE DE BREVET EUROPEEN

(11) **EP 4 498 515 A1**
(43) Date de publication de la demande: **29.01.2025**
(21) Numéro de dépôt: 24190252.7
(22) Date de dépôt: 23.07.2024
(51) Int. Cl.: H01Q 1/24, H01Q 23/00, H01Q 9/28, H01L 29/16, H01L 29/417, H01L 29/66, H01L 29/88

(54) **DISPOSITIF RECTIFICATEUR A DIODE COUPLEE A UNE ANTENNE**

(30) Priorité: 25.07.2023 FR 2308001
(71) Demandeur: Commissariat à l'Energie Atomique et aux Energies Alternatives, 75015 Paris (FR)
(72) Inventeur: ALIANE, Abdelkader, 38054 Grenoble cedex 09 (FR); KAYA, Hacile, 38054 Grenoble cedex 09 (FR); VIALLE, Claire, 38054 Grenoble cedex 09 (FR)
(74) Mandataire: Brevalex

(57) **Abrégé**

L'invention porte sur un dispositif rectificateur 1 à diode 20 de type MIIM couplée à une antenne 10, dans lequel la diode 20 comporte une couche semiconductrice 23 en graphène G située entre les première et deuxième couches isolantes 22, 24 de la diode MIIM, et dans lequel la première couche métallique 21 de la diode MIIM est réalisée en un premier métal M1 présentant un travail de sortie Ψ_{M1} inférieur ou égal au travail de sortie Ψ_{G} du graphène G.

## Description

### DOMAINE TECHNIQUE

Le domaine de l'invention est celui des dispositifs rectificateurs à diode couplée à une antenne, également appelés « rectennas ». L'invention trouve une application notamment dans le domaine de la détection infrarouge ou térahertz, et dans celui de la conversion énergétique.

### ÉTAT DE LA TECHNIQUE ANTÉRIEURE

Les détecteurs infrarouges et térahertz qui fonctionnent à température ambiante peuvent être, par exemple, des détecteurs thermiques de type bolomètre. Ils peuvent alors comporter une membrane absorbante, suspendue au-dessus d'un substrat contenant un circuit de lecture, qui contient un matériau thermistor dont la résistance électrique varie en fonction de son échauffement. Cependant, les performances de ces détecteurs thermiques sont généralement limitées par leur constante de temps thermique, qui peut être de l'ordre de la dizaine de millisecondes.

Les détecteurs infrarouges et térahertz peuvent également être des dispositifs rectificateurs à diode couplée à une antenne, également appelés « antennes rectificatrices » ou « rectennas », où la diode peut être de type MIM (métal - isolant - métal). Ces rectennas peuvent présenter un temps de réponse bien plus rapide que celui des détecteurs thermiques de type bolomètre, dans la mesure où le temps de transit des électrons par effet tunnel, au travers de la couche mince isolante de la diode, est de l'ordre de la femtoseconde à la nanoseconde.

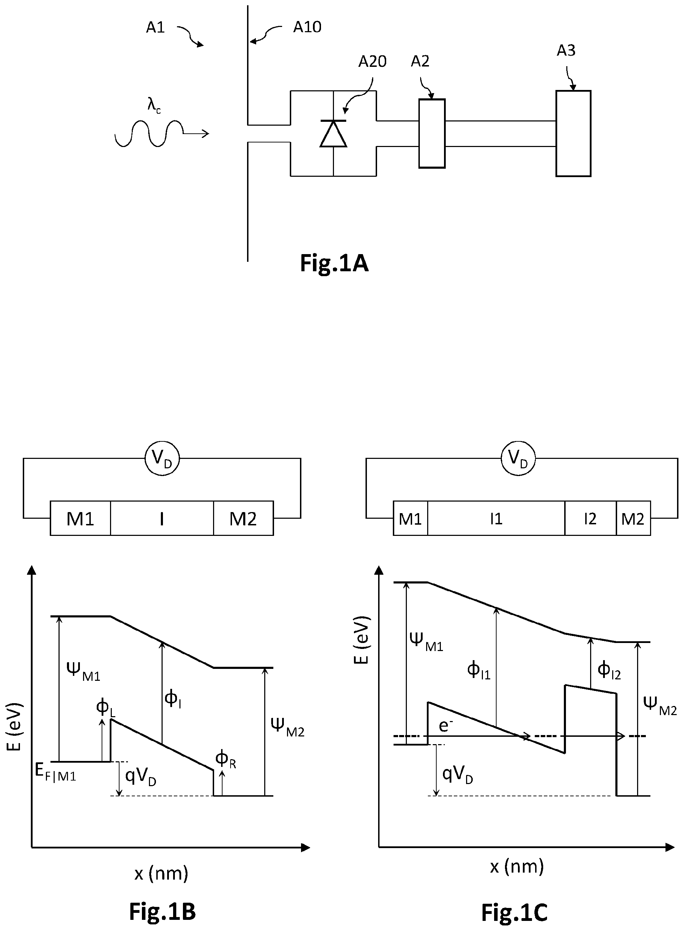

La figure 1A illustre le schéma de principe d'une rectenna A1, ici dans le cas d'une application de conversion énergétique. Elle est formée d'une antenne A10 adaptée à absorber le rayonnement électromagnétique incident, et d'un élément redresseur A20 tel qu'une diode, par exemple une diode de type MIM, couplée électriquement à l'antenne A10. Un filtre DC A2 est généralement connecté en parallèle de la diode A20 pour ne garder que la composante continue du signal AC redressé. Le principe de fonctionnement d'une telle rectenna A1 est le suivant : l'antenne A10 absorbe le rayonnement électromagnétique incident et le convertit en un signal électrique haute fréquence, lequel est transféré à l'entrée de la diode A20. La diode A20 redresse le signal électrique AC, puis le filtre DC A2 ne garde que la composante continue du signal électrique redressé, pour le fournir ici à une charge électrique A3.

La figure 1B illustre un exemple d'un diagramme de bande d'énergie d'une rectenna à diode MIM, ici dans le cas d'une application de détection optique. Une telle rectenna est décrite notamment dans l'article de de Graver & Moddel intitulé Applicability of Metal/Insulator/Metal (MIM) Diodes to Solar Rectennas, IEEE Journal of Photovoltaics, Vol. 1, no. 1, pp. 78-83, 2011. La diode MIM comporte deux couches métalliques (métaux M1 et M2) entre lesquelles est située une même couche isolante (isolant électrique I). Le diagramme dépend en particulier des valeurs des travaux de sortie Ψ_{M1} et Ψ_{M2} des métaux M1 et M2, de l'affinité électronique φ_{I} de l'isolant I, et de la tension de polarisation V_{D} appliquée à la diode MIM. Les électrons peuvent traverser la barrière d'énergie selon différents mécanismes de conduction, par exemple par effet tunnel de type Fowler-Nordheim ou par effet tunnel direct, en fonction notamment des hauteurs φ_{L} et φ_{R} des barrières d'énergie. Ces différents types de mécanismes de conduction sont décrits notamment dans l'article de Chiu intitulé A Review on Conduction Mechanisms in Dielectric Films, Advances in Materials Science and Engineering, vol. 2014, Article ID 578168, 18 pages, 2014. Dans cet exemple, la conduction par effet tunnel est de type Fowler-Nordheim. Notons qu'il existe également des rectennas à diode MIG, où la couche métallique M2 est remplacée par une couche de graphène G, comme décrit notamment dans l'article de Hemmetter et al. intitulé Terahertz Rectennas on Flexible Substrates Based on One-Dimensional Metal-Insulator-Graphene Diodes, ACS Appl. Electron. Mater. 2021, 3, 3747-3753.

Comme l'indique l'article de Grover & Moddel 2011, en termes de performances, on cherche à ce que la diode MIM présente une haute responsivité, ce paramètre β correspondant à une mesure du signal DC rectifié en fonction de la puissance énergétique incidente. On peut la déterminer à partir de la caractéristique I(V) de la diode à partir de la relation : β = I"/(2I'), où l' et I" sont les dérivées première et deuxième du courant électrique en fonction de la tension électrique I(V), à la tension de polarisation V_{D}. De plus, on cherche également à ce que la diode présente une résistance dynamique faible pour obtenir une bonne adaptation d'impédance avec l'antenne.

Cependant, il apparaît que, pour une diode MIM, c'est-à-dire une diode avec une seule couche isolante située entre les deux couches métalliques, l'optimisation de la responsivité conduit à une dégradation de la valeur de la résistance dynamique, et inversement. Aussi, il ne semble pas possible d'optimiser à la fois la responsivité et la résistance dynamique d'une diode MIM. Or, il apparaît qu'une diode MIIM, c'est-à-dire une diode avec deux couches isolantes ayant des affinités électroniques différentes, permet de lever cette contrainte, de sorte qu'il est possible de configurer la diode MIIM pour qu'elle présente à la fois une responsivité élevée et une résistance dynamique faible. C'est en particulier le cas lorsque la diode MIIM autorise une conduction des porteurs de charge par effet tunnel résonant.

A ce titre, la figure 1C illustre un exemple d'un diagramme de bande d'énergie d'une rectenna infrarouge à diode MIIM configurée pour autoriser une conduction des porteurs de charge, ici des électrons, par effet tunnel résonant. Ce type de diagramme de bande d'énergie est décrit notamment dans l'article de Grover & Moddel intitulé Engineering the current-voltage characteristics of metol-insulotor-metol diodes using double-insulator tunnel barriers, Solid-State Electron. 67, 94-99 (2012), ainsi que dans celui de Belkadi et al. intitulé Démonstration of résonant tunneling effects in metol-double-insulotor-metol (MI2M) diodes, Nat Commun 12, 2925 (2021).

L'effet tunnel résonant est présent lorsque les électrons traversent les couches isolantes en passant par un puits quantique en forme de triangle rectangle situé entre les deux couches isolantes. Les électrons dont l'énergie correspond aux niveaux d'énergie des états quasi-liés du puits quantique peuvent traverser les couches isolantes et atteindre la couche métallique M2 en minimisant la réflexion, produisant ainsi un courant électrique plus élevé que dans le cas d'un effet tunnel non résonant. Notons que, dans cet exemple, les électrons traversent la première couche isolante par effet tunnel de type Fowler-Nordheim, et la deuxième couche isolante par effet tunnel direct. Les auteurs ont montré qu'en utilisant des isolants à affinités électroniques différentes, il est possible de configurer une diode de type MIIM à effet tunnel résonant pour obtenir à la fois une responsivité élevée et une résistance dynamique faible, ce qui n'est pas possible d'obtenir dans le cas d'une diode MIM.

Cependant, il existe un besoin d'améliorer encore les performances d'une rectenna à diode de type MIIM, que ce soit pour des applications de détection infrarouge ou térahertz, ou même de conversion d'énergie.

### EXPOSÉ DE L'INVENTION

L'invention a pour objectif de remédier au moins en partie aux inconvénients de l'art antérieur, et plus particulièrement de proposer un dispositif rectificateur à diode de type MIIM couplée à une antenne infrarouge présentant des performances améliorées.

Pour cela, l'objet de l'invention est un dispositif rectificateur comportant : une antenne adaptée à absorber un rayonnement électromagnétique d'intérêt; et une diode de type MIIM couplée électriquement à l'antenne. La diode MIIM comporte : une première couche métallique et une deuxième couche métallique ; et une première couche isolante réalisée en un premier isolant électrique présentant une affinité électronique φ₁, et une deuxième couche isolante réalisée en un deuxième isolant électrique présentant une affinité électronique φ₂ différente de φ₁.

Selon l'invention, la diode comporte une couche semiconductrice en graphène située entre les première et deuxième couches isolantes. De plus, la première couche métallique est réalisée en un premier métal présentant un travail de sortie Ψ_{M1} inférieur ou égal au travail de sortie Ψ_{G} du graphène.

Certains aspects préférés mais non limitatifs de ce dispositif rectificateur sont les suivants.

La couche semiconductrice de graphène peut être formée d'au plus deux feuilles monoatomiques.

Les première et deuxième couches isolantes peuvent présenter une épaisseur comprise entre 0.5 et 2nm.

Les première et deuxième couches métalliques peuvent présenter une épaisseur au moins égale à 80nm.

Les affinités électroniques φ₁ et φ₂ des premier et deuxième isolants électriques peuvent être inférieures au travail de sortie Ψ_{G} du graphène.

Le dispositif rectificateur peut comporter une source électrique adaptée à appliquer une tension électrique de polarisation V_{D} non nulle à la diode.

La source électrique peut être adaptée à appliquer un potentiel électrique à la première et à la deuxième couche métallique, le potentiel électrique appliqué à la deuxième couche métallique étant supérieur à celui appliqué à la première couche métallique.

La première couche métallique peut présenter un potentiel électrique égal à celui de la deuxième couche métallique.

Le dispositif rectificateur peut comporter un réflecteur du rayonnement électromagnétique d'intérêt, situé entre un substrat support et l'antenne, et espacé de l'antenne de manière à former une cavité quart d'onde.

L'antenne peut être adaptée à absorber un rayonnement électromagnétique dans l'infrarouge ou le térahertz.

L'invention porte également sur un système optoélectronique comportant une matrice de dispositifs rectificateurs selon l'une quelconque des caractéristiques précédentes, identiques les uns aux autres.

L'invention porte également sur un procédé de fabrication d'un dispositif rectificateur selon l'une quelconque des caractéristiques précédentes, comportant les étapes suivantes :
- réalisation d'une première partie conductrice de l'antenne ;
- réalisation de la première couche métallique de la diode, en contact électrique de la première partie conductrice de l'antenne ;
- réalisation d'une première couche isolante continue, réalisée en le premier isolant électrique, en contact électrique de la première couche métallique ;
- réalisation d'une couche semiconductrice continue de graphène, au contact de la couche isolante continue ;
- réalisation d'une deuxième couche isolante continue, réalisée en le deuxième isolant électrique, au contact de la couche semiconductrice continue de graphène ;
- structuration de la première couche isolante continue, de la couche semiconductrice continue et de la deuxième couche isolante continue, de manière à former la première couche isolante, la couche semiconductrice de graphène, et la deuxième couche isolante de la diode ;
- réalisation de la deuxième couche métallique de la diode, en contact électrique de la deuxième couche isolante de la diode ;
- réalisation d'une deuxième partie conductrice de l'antenne, en contact électrique de la deuxième couche métallique de la diode.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :
la figure 1A, déjà décrite, est une vue schématique d'un dispositif rectificateur à diode couplée à une antenne, selon un exemple de l'art antérieur ;
la figure 1B, déjà décrite, illustre un exemple de diagramme de bande d'énergie d'un dispositif rectificateur à diode MIM, selon un exemple de l'art antérieur ;
la figure 1C, déjà décrite, illustre un exemple de diagramme de bande d'énergie d'un dispositif rectificateur à diode MIIM, selon un exemple de l'art antérieur ;
la figure 2A illustre un diagramme de bande d'énergie d'un dispositif rectificateur à diode MIGIM selon un mode de réalisation ;
la figure 2B et la figure 2C sont des vues schématiques et partielles, en coupe transversale (fig.2B) et en vue de dessus (fig.2C), d'un dispositif rectificateur à diode MIGIM selon un mode de réalisation ;
la figure 3A illustre une évolution du taux d'absorption de l'antenne d'un dispositif rectificateur à diode MIGIM selon un mode de réalisation ;
la figure 3B illustre une caractéristique I(V) d'une diode MIGIM d'un dispositif rectificateur selon un mode de réalisation ;
les figures 4A à 4M illustrent différentes étapes d'un procédé de fabrication d'un dispositif rectificateur à diode MIGIM selon un mode de réalisation.

### EXPOSÉ DÉTAILLÉ DE MODES DE RÉALISATION PARTICULIERS

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux. Sauf indication contraire, les termes « sensiblement », « environ », « de l'ordre de » signifient à 10% près, et de préférence à 5% près. Par ailleurs, les termes « compris entre ... et ... » et équivalents signifient que les bornes sont incluses, sauf mention contraire.

L'invention porte sur un dispositif rectificateur à diode couplée à une antenne, également appelé « rectenna ». Il peut faire office de détecteur infrarouge ou térahertz, voire de convertisseur énergétique, selon notamment que la diode est polarisée, ou non, à une tension non nulle V_{D}.

D'une manière générale, l'antenne de la rectenna peut être adaptée à absorber un rayonnement électromagnétique d'intérêt dans une gamme spectrale allant notamment de l'infrarouge au térahertz. Ainsi, l'antenne peut être configurée pour absorber dans le proche infrarouge (SWIR, pour *Short Wavelength IR,* en anglais) correspondant à une gamme spectrale allant de 0,8 à 2,7µm environ ; dans le moyen infrarouge (MWIR, pour *Middle Wavelength IR,* en anglais) correspondant à une gamme spectrale allant de 3 à 5µm environ ; dans l'infrarouge lointain (LWIR, pour *Long Wavelength IR,* en anglais) correspondant à une gamme spectrale allant de 7 à 14µm environ ; voire encore dans le térahertz dont la gamme spectrale va de 0.1 à 1mm environ (0.3 à 3THz environ).

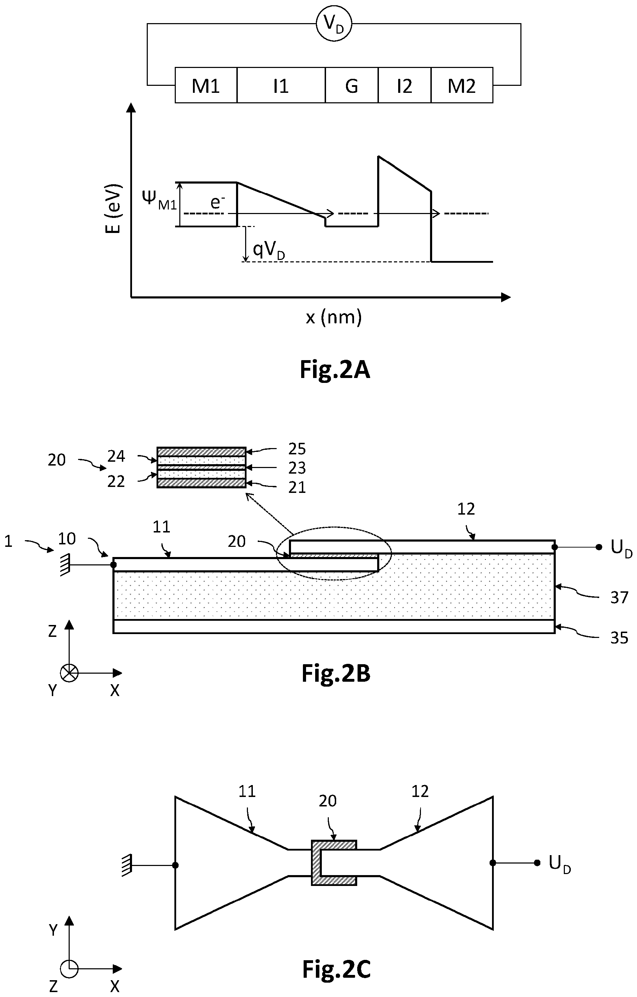

La figure 2A est une vue très schématique d'une rectenna selon un mode de réalisation, ainsi que d'un exemple de son diagramme de bande d'énergie. Les figures 2B et 2C sont des vues schématiques et partielles en coupe longitudinale (fig.2B) et en vue de dessus (fig.2C) d'une rectenna 1 selon un mode de réalisation.

On définit ici et pour la suite de la description un repère direct tridimensionnel XYZ, où le plan XY (plan principal) est parallèle au plan principal de l'antenne 10 de la rectenna 1, et où l'axe Z est orienté suivant l'épaisseur de la diode 20 de la rectenna 1. Par ailleurs, les termes « inférieur » et « supérieur » s'entendent comme étant relatifs à un positionnement croissant suivant la direction +Z.

Dans cet exemple, la rectenna 1 est un détecteur infrarouge dont l'antenne est adaptée à absorber dans l'infrarouge LWIR, avec une longueur d'onde centrale égale à 10µm environ. Bien entendu, la rectenna 1 peut être configurée pour absorber dans les autres gammes spectrales de l'infrarouge, voire dans le térahertz.

De préférence, la rectenna 1 décrite appartient à une matrice de rectennas unitaires, identiques les unes aux autres, connectées à un circuit électrique de commande et de lecture (ROIC) chargé de polariser les diodes 20 et lire les signaux électriques générés.

Comme expliqué en détail plus loin, la rectenna 1 comporte une diode 20 de type MIIM qui comprend une couche semiconductrice 23 de graphène située entre les deux couches isolantes 22, 24. La diode 20 est alors appelée diode MIGIM.

D'une manière générale, la rectenna 1 comporte une antenne 10, la diode MIGIM 20 et un filtre DC (non représenté). Elle comporte ici une source électrique pour polariser la diode MIGIM à une tension non nulle V_{D} (application en détection optique). En revanche, dans le cas d'une application de conversion énergétique (cellule solaire, par ex.), la diode MIGIM peut être non polarisée ou polarisée à une tension nulle, et peut être connectée à une charge électrique.

L'antenne 10 est adaptée à absorber le rayonnement électromagnétique incident, ici un rayonnement infrarouge LWIR et est électriquement connectée à la diode MIGIM 20 pour lui transmettre le signal électrique généré en réponse à l'absorption du rayonnement infrarouge d'intérêt.

L'antenne 10 comprend au moins deux parties 11, 12 électriquement conductrices, réalisées en au moins un métal absorbant, comme par exemple du Ti, TiN, AI, Au, Pt, entre autres. Les parties conductrices 11, 12 sont alignées suivant un axe principal X de détection. Dans cet exemple, l'antenne 10 comporte deux parties conductrices s'étendant suivant un même axe principal X, mais en variante (non représentée), elle peut comporter davantage de parties conductrices, par exemple quatre parties conductrices dont deux s'étendent suivant un premier axe principal, et deux s'étendent suivant un deuxième axe principal orthogonal au premier axe.

L'antenne 10 peut présenter une forme de spirale, de serpentin, de dipôle, de noeud papillon *(bow-tie* en anglais). Dans cet exemple, l'antenne 10 est de type noeud papillon, également appelée antenne papillon. Les deux parties conductrices 11, 12 présentent une forme sensiblement plane et triangulaire dans le plan XY, où les sommets des triangles sont situés en regard, suivant l'axe vertical Z, de la diode 20. L'antenne 10 présente une longueur L suivant l'axe principal X de l'ordre de λ_{c}/2, où λ_{c} est la longueur d'onde centrale de la gamme spectrale LWIR, par exemple ici 10µm environ. L'ouverture angulaire de chaque partie conductrice 11, 12 de forme triangulaire, définie au niveau des sommets en regard de la diode 20, peut être égale à 60° environ. Enfin, l'antenne peut présenter une résistance R_{A} de l'ordre de 100 Ω.

Les deux parties conductrices 11, 12 sont séparées l'une de l'autre, et sont connectées électriquement l'une à l'autre par le biais de la diode 20. Elles sont disposées de part et d'autre de la diode 20 suivant l'axe principal X. Ainsi, comme l'illustrent les fig.2B et 2C, une partie conductrice inférieure 11 est en contact électrique avec une couche métallique inférieure 21 de la diode 20, et une partie conductrice supérieure 12 est en contact électrique avec une couche conductrice supérieure 25 de la diode 20.

La diode 20 est adaptée à recevoir le signal électrique AC haute fréquence généré par l'antenne 10 en réponse à l'absorption du rayonnement électromagnétique d'intérêt, ici dans le LWIR, et à le rectifier pour fournir un signal électrique AC rectifié.

La diode 20 est formée d'un empilement des deux couches métalliques 21, 25, entre lesquelles sont situées au moins deux couches isolantes 22, 24. De plus, une couche semiconductrice 23 en graphène est située entre et au contact des deux couches isolantes 22, 24. Aussi, la diode 20 est de type MIIM et est appelée MIGIM.

Dans cet exemple, l'empilement des couches 21, 22, 23, 24, 25 est orienté suivant l'axe vertical Z. La couche métallique inférieure 21 est en contact électrique avec l'extrémité proximale de la partie conductrice 11 de l'antenne 10, et la couche métallique supérieure 25 est en contact électrique avec l'extrémité proximale de la partie conductrice 12. Par extrémités proximales, on entend les extrémités des parties conductrices 11, 12 orientées l'une vers l'autre.

Dans cet exemple, la diode 20 comporte deux couches isolantes 22, 24, de sorte que chaque couche isolante 22, 24 est au contact d'une couche métallique 21, 25 et de la couche semiconductrice 23 de graphène. En variante, la diode 20 peut comporter plusieurs couches isolantes et plusieurs couches semiconductrices de graphène, où chaque couche semiconductrice de graphène est située entre et au contact de deux couches isolantes.

La première couche métallique 21 (couche inférieure) est réalisée en au moins un premier métal M1 dont le travail de sortie est noté Ψ_{M1}. Elle est ici au contact de la première couche isolante 22. La deuxième couche métallique 25 (couche supérieure) est réalisée en au moins un deuxième métal M2, dont le travail de sortie est noté Ψ_{M2}. Elle est ici au contact de la deuxième couche isolante 24.

Dans le cas ici d'une application de détection optique, les deux métaux M1 et M2 peuvent être identiques ou différents en termes de travaux de sortie. En revanche, dans le cas d'une application de conversion énergétique, les travaux de sortie Ψ_{M1}, Ψ_{M2} sont différents l'un de l'autre. Par travaux de sortie différents l'un de l'autre, on entend que le travail de sortie Ψ_{M1} du métal M1 présente un écart relatif vis-à-vis du travail de sortie Ψ_{M2} du métal M2 supérieur à 10%. Autrement dit, on a ΔΨ_{M1M2}/Ψ_{M1} = |Ψ_{M1}-Ψ_{M2}|/Ψ_{M1} > 10%.

Par ailleurs, le premier métal M1 est choisi de sorte que son travail de sortie Ψ_{M1} est inférieur ou égal au travail de sortie Ψ_{G} de 4.5eV du graphène. Par travaux de sortie égaux l'un à l'autre, on entend que le travail de sortie Ψ_{M1} du métal M1 présente un écart relatif vis-à-vis du travail de sortie Ψ_{G} du graphène inférieur ou égal à 10%. Autrement dit, on a ΔΨ_{M1G}/Ψ₁ = |Ψ_{M1}-Ψ_{G}|/Ψ₁ ≤ 10%.

Le métal M1 peut être choisi notamment parmi le Ti, Cr, TiN et AlCu, et le métal M2 peut être choisi, dans le cas ici où on choisit M1 différent de M2, parmi le Ni, Pt, et Au. Ainsi, dans le cas où le métal M1 est du titane Ti, il présente un travail de sortie Ψ_{M1} de l'ordre de 4.3eV, de sorte que l'écart relatif avec le travail de sortie Ψ_{G} de 4.5eV du graphène est ici égal à 4.6%. On a donc bien Ψ_{M1} ≤ Ψ_{G}.

La première couche isolante 22 (couche inférieure) est située ici au contact de la première couche métallique 21 et de la couche semiconductrice 23 de graphène. Elle est réalisée en un matériau électrique isolant I1 d'affinité électronique φ₁. La deuxième couche isolante 24 (couche supérieure) est située ici au contact de la couche semiconductrice 23 de graphène et de la deuxième couche métallique 25. Elle est réalisée en un matériau électrique isolant I2 d'affinité électronique φ₂ différente de φ₁. Autrement dit, l'affinité électronique φ₁ présente un écart relatif vis-à-vis de l'affinité électronique φ₂ supérieur à 10%. Autrement dit, on a Δφ₁₂/φ₁ = |φ₁-φ₂|/φ₁ > 10%.

Les couches isolantes 22, 24 peuvent être réalisées en des matériaux électriquement isolants tels que les oxydes d'aluminium, d'hafnium, de zirconium, de silicium, de zinc entre autres, comme par exemple l'Al₂O₃, l'HfO₂, l'HfAlO, ZrO₂, SiO₂, ZnO. Les matériaux isolants peuvent de préférence être des matériaux à constante diélectrique élevée (matériaux *high-k*), comme par exemple Al₂O₃, HfO₂,ZrO₂ et ZnO, de manière à augmenter l'asymétrie de la diode 20 et à réduire sa résistance dynamique. De plus, les isolants I1 et I2 sont choisis de sorte que les affinités électroniques φ₁, φ₂ sont inférieures au travail de sortie Ψ_{G} du graphène, de manière à permettre la formation d'un puits quantique.

Les couches isolantes 22, 24 présentent des épaisseurs de l'ordre de quelques dixièmes de nanomètres à quelques nanomètres, de préférence comprises entre 0.5 et 2nm, par exemple égales à 0.5nm, 1nm, voire davantage. Les épaisseurs peuvent être identiques ou non.

Les couches isolantes 22, 24 sont des couches minces, c'est-à-dire des couches présentant une épaisseur allant d'une couche atomique à une dizaine de nanomètres environ. Elle peut être réalisée par les techniques classiques de la microélectronique, dont le dépôt chimique (CVD, ALD...), le dépôt physique (PVD...), entre autres.

Selon l'invention, une couche semiconductrice 23 de graphène G est située entre et au contact des deux couches isolantes 22, 24. Le graphène est un matériau cristallin bidimensionnel formé d'un ou plusieurs feuilles d'atomes de carbone disposés en hexagone pour former une structure plane d'épaisseur monoatomique. Le graphène présente un travail de sortie égal à 4.3eV environ. Une feuille correspond à une couche monoatomique. La couche semiconductrice 23 de graphène présente une épaisseur d'une à quelques feuilles, et de préférence au plus deux feuilles. L'épaisseur d'une feuille de graphène est de 0.34nm, et celle de deux feuilles est de 0.68nm.

Ainsi, par le fait que le travail de sortie Ψ_{M1} du métal M1 est inférieur ou égal à celui du graphène, la diode MIGIM 20 présente un diagramme de bande d'énergie mettant en évidence un puits quantique situé entre les deux couches isolantes 22, 24 et formé par la couche semiconductrice 23 de graphène. Elle autorise une très bonne transmission des électrons par effet tunnel résonant, du fait notamment des propriétés de conduction du graphène. Comme détaillé par la suite, il apparaît que la diode 20 présente une forte asymétrie de sa caractéristique I(V) et donc une forte responsivité, ainsi qu'une faible résistance dynamique.

La rectenna 1 comporte également un filtre DC (non représenté), connecté électriquement à la diode 20, de manière à filtrer le signal électrique AC rectifié pour ne garder que la composante continue DC. Le filtre est ensuite connecté électriquement à un circuit de lecture du signal électrique (application de détection optique) ou à une charge électrique (application de conversion énergétique).

Une source électrique peut être présente pour polariser électriquement la diode 20 à une tension de polarisation V_{D}. A titre d'exemple, la couche métallique M1 est mise à la masse alors que la couche métallique M2 est portée au potentiel électrique U_{D}, lequel peut être nul ou non nul en fonction de l'application visée. De préférence, dans le cas d'une application de détection optique, le potentiel électrique U_{D} appliqué à la couche métallique 25 est positif et supérieur à celui appliqué à la couche métallique 21. Le tension électrique V_{D} peut être comprise entre 0 et 0.2 V environ.

Rappelons ici que les performances de la rectenna 1 dépendent notamment de la résistance dynamique R_{D} de la diode 20, de l'asymétrie As_{D} de la caractéristique I(V), et de la responsivité β. La résistance dynamique R_{D} peut être déterminée à partir de la relation R_{D} = 1/I', où l' est la dérivée première du courant électrique I en fonction de la tension électrique V, à la tension de polarisation V_{D}. L'asymétrie As_{D} peut être déterminée à partir de la relation As_{D} = |I_{f}/Iᵣ|, à la tension de polarisation V_{D}, où I_{f} est la valeur du courant électrique en direct et Iᵣ est celle du courant électrique en inverse. Enfin, la responsivité β a été définie précédemment et peut être déterminée par la relation : β = I"/(2I').

Ainsi, la rectenna 1 comporte une diode de type MIGIM où une couche semiconductrice 23 de graphène est située entre les deux couches isolantes 22, 24 d'affinités électroniques différentes. De plus, le métal M1 présente un travail de sortie Ψ_{M1} inférieur ou égal au travail de sortie Ψ_{G} du graphène. Du fait de ces caractéristiques, la diode MIGIM 20 autorise la transmission des porteurs de charge par effet tunnel résonant, tout en augmentant l'asymétrie de la caractéristique I(V) et donc la responsivité, et en réduisant la résistance dynamique faible. Ainsi, l'efficacité de redressement du signal électrique est améliorée, ainsi que l'efficacité de couplage de la diode 20 avec l'antenne 10. La rectenna 1 présente alors des performances améliorées par rapport à celle des rectennas conventionnelles à diode MIIM.

Notons par ailleurs que la polarisation électrique de la couche semiconductrice 23 de graphène entraîne une modification de l'énergie de bande interdite. Celle-ci peut ainsi varier entre 0.0001 et 0.29eV en fonction de la valeur de la tension de polarisation V_{D}. Cette polarisation de la couche semiconductrice 23 peut être avantageuse dans le cas où la couche semiconductrice 23 est formée d'au moins deux monocouches de graphène. Dans ce cas, le fait d'appliquer un champ électrique va faire varier la largeur de la bande interdite, et donc le travail de sortie du graphène. Ceci peut donc permettre de contrôler ce travail de sortie du graphène par rapport au travail de sortie du métal M1 afin d'avoir un large choix de métaux pour le métal M1 et d'affiner aussi l'effet résonnance tunnel.

A titre d'exemple, on considère une rectenna infrarouge 1 adaptée à absorber dans le LWIR, et comportant une diode MIGIM 20. L'antenne 10 est de type papillon et présente une longueur totale L de l'ordre de λ_{c}/2 suivant l'axe principal X, où λ_{c} est la longueur d'onde centrale du rayonnement LWIR à détecter. La longueur L est ici égale à 4µm environ, et l'ouverture angulaire des parties conductrices triangulaires 11, 12 de l'antenne 10 est de l'ordre de 60°. L'antenne 10 est située au-dessus d'un réflecteur métallique 35, et en est espacée verticalement d'une épaisseur de l'ordre de λ_{c}/4n, où n est l'indice optique du milieu 37 séparant l'antenne 10 du réflecteur 35. Ici, ce milieu 37 est un oxyde de silicium d'une épaisseur de l'ordre de 1µm environ. On forme ainsi une cavité quart d'onde qui améliore le taux d'absorption par l'antenne 10.

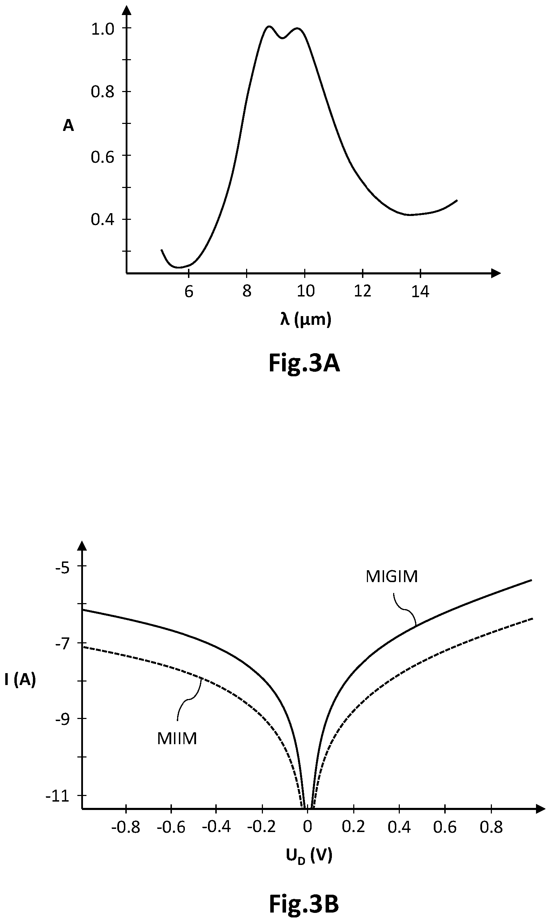

La figure 3A illustre un exemple d'évolution du taux d'absorption A en fonction de la longueur d'onde λ du rayonnement électromagnétique incident. Il apparaît que cette antenne présente une très bonne absorption optique A, de l'ordre de 100%, pour une gamme spectrale de 8.5 à 10 µm environ. De plus, l'antenne présente une résistance de l'ordre de 100 Ω autour de la longueur d'onde centrale λ_{c} de 10µm.

La figure 3B illustre des exemples de courbes I(V) de la diode de la rectenna, dans le cas où la diode est une diode MIIM conventionnelle, et dans le cas où la diode est de type MIGIM. Les deux cas diffèrent l'un de l'autre uniquement en la présence ou non de la couche semiconductrice de graphène. La diode est formée ici d'une première couche métallique en Ti, d'une première couche isolante en Al₂O₃ d'une épaisseur de 0.5nm, d'une deuxième couche isolante en HfO₂ d'une épaisseur de 1nm, et enfin d'une deuxième couche métallique en Ni. La diode présente des dimensions de 100nmx100nm dans le plan XY.

Notons que les deux isolants I1, I2 sont ici choisis parmi les isolants à haute constante diélectrique (matériaux dits *high-k* en anglais), ce qui permet d'augmenter l'asymétrie de la diode, et de contribuer à réduire la résistance dynamique. En effet, l'Al₂O₃ présente une constante diélectrique de l'ordre de 6 à 7 en couche très mince, et l'HfO₂ présente une constante diélectrique de l'ordre de 10 à 12 en couche mince. Par ailleurs, l'Al₂O₃ présente une affinité électronique φ₁ de l'ordre de 1.3eV, et l'HfO₂ présente une affinité électronique φ₂ de l'ordre de 2.5eV.

Enfin, notons que le Ti présente un travail de sortie Ψ_{M1} de 4.3eV, et le Ni présente un travail de sortie Ψ_{M2} de 5eV. Le Ti présente ici un travail de sortie Ψ_{M1} différent de Ψ_{M2} dans la mesure où l'écart relatif (ici ΔΨ_{M1M2}/Ψ₁) est ici égal à 16% environ, donc supérieur à 10%. De plus, le Ti présente un travail de sortie Ψ_{M1} sensiblement égal au travail de sortie Ψ_{G} de 4.5eV du graphène à au plus 10%. En effet, l'écart relatif (ici ΔΨ_{M1G}/Ψ₁) est ici égal à 4% environ, donc inférieur à 10%.

Il apparaît que la présence de la couche semiconductrice de graphène se traduit par une courbe I(V) montrant une réduction de la résistance dynamique R_{D} de la diode (autorisant alors un courant électrique plus élevé). Aussi, l'efficacité de couplage de la diode avec l'antenne est améliorée. De plus, la courbe I(V) de la diode MIGIM présente une asymétrie plus importante que dans le cas de la diode MIIM, traduisant un meilleur redressement du signal électrique alternatif, et donc une amélioration de la responsivité de la diode MIGIM. Les performances de la rectenna à diode MIGIM sont donc effectivement améliorées par rapport à celle de la rectenna à diode MIIM.

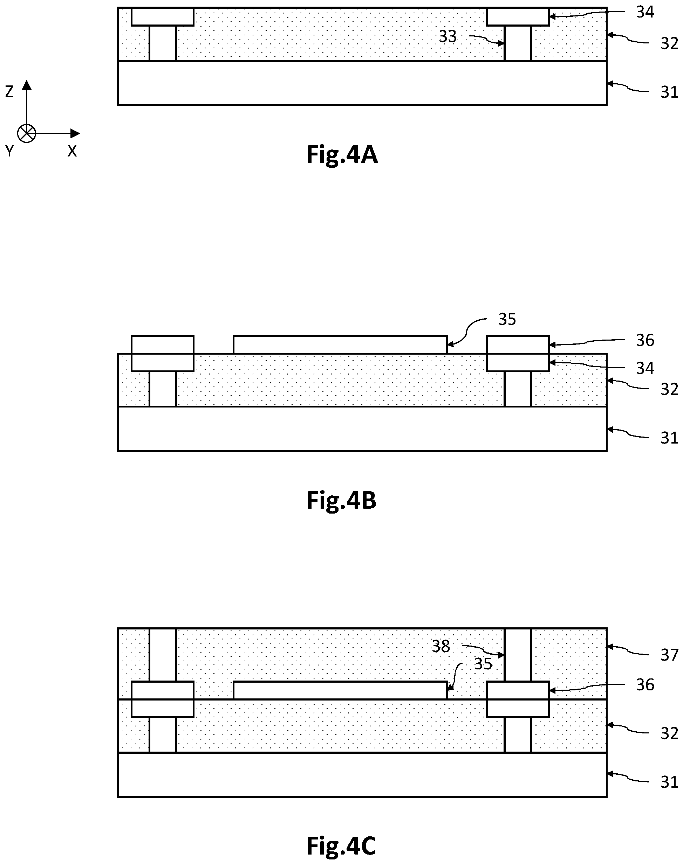

Les figures 4A à 4M illustrent différentes étapes d'un procédé de fabrication d'une rectenna 1 selon un mode de réalisation. La rectenna 1 est ici adaptée à absorber un rayonnement électromagnétique d'intérêt dans le LWIR. On ne représente ici qu'une seule rectenna, mais de préférence, le procédé porte sur la fabrication d'une matrice de rectennas identiques sur un même substrat de lecture 31.

En référence à la fig.4A, on fournit un substrat de lecture 31, contenant un circuit de lecture et de commande (ROIC), par exemple de type CMOS, adapté ici à polariser électriquement la diode et à lire le signal électrique rectifié issu de la rectenna en réponse à l'absorption du rayonnement LWIR.

Le substrat de lecture 31 est recouvert d'une couche isolante inférieure 32, réalisée en un matériau isolant tel qu'un oxyde de silicium. On réalise ensuite, au travers de la couche isolante inférieure 32, des premiers vias conducteurs 33, connectés à des plots de connexion du substrat de lecture 31 (non représentés), puis des premiers plots de connexion électrique 34 au contact des vias conducteurs 33.

En référence à la fig.4B, on réalise ensuite le réflecteur 35 et des plots de connexion intermédiaire 36. Pour cela, on dépose une couche en au moins un matériau métallique, que l'on structure par lithographie et gravure localisée pour former le réflecteur 35 et des plots de connexion 36. La couche métallique peut être un multicouche, par exemple de type Ti/TiN/AICu ou Ti/TiN/AISi. Le AlCu ou le AISi peut présenter une épaisseur d'au moins 80nm, par exemple égale à 300nm. Les plots de connexion 36 sont en contact électrique avec les plots de connexion 34.

En référence à la fig.4C, on dépose une couche isolante intermédiaire 37, réalisée en un matériau isolant tel qu'un oxyde de silicium, de manière à définir ensuite la cavité quart d'onde avec l'antenne. On peut ainsi déposer du SiO₂ par dépôt physique en phase vapeur assisté par plasma (PECVD), d'une épaisseur de 1.2µm, à une température de dépôt inférieure ou égale à 400°C pour respecter le budget thermique du circuit de lecture CMOS. Une étape de polissage mécano-chimique peut ensuite être effectuée pour retirer un excès de matériau et planariser la couche isolante intermédiaire 37 à une épaisseur de 1µm environ. On réalise ensuite des deuxièmes vias conducteurs 38, au travers de la couche isolante intermédiaire 37, venant au contact des plots de connexion 36.

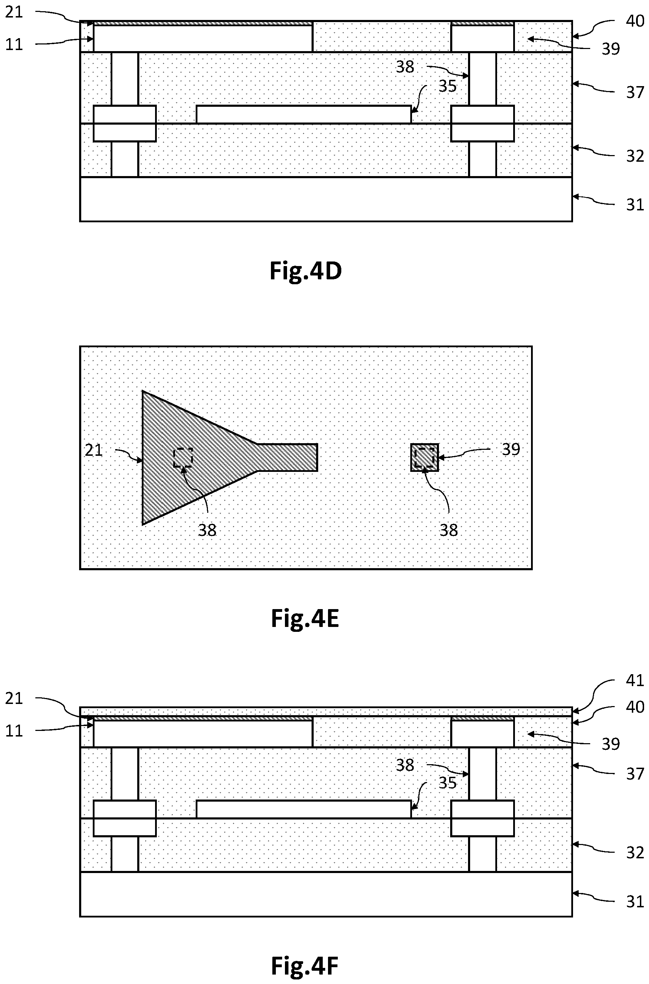

En référence à la fig.4D et à la fig.4E, on réalise ensuite la partie conductrice inférieure 11 de l'antenne ainsi que la couche métallique inférieure 21 de la diode. Pour cela, on dépose une couche en au moins un matériau métallique, que l'on structure par lithographie et gravure. La couche est de préférence formée d'un multicouche métallique, par exemple en Ti/TiN/AICu. Ce multicouche forme à la fois la partie conductrice inférieure 11 de l'antenne et la couche métallique inférieure 21 en AlCu de la diode. Le multicouche peut présenter une épaisseur totale de préférence comprise entre 200 et 500nm. La couche métallique 21 en AlCu présente une épaisseur de préférence supérieure à 80nm pour s'assurer de la qualité et de la continuité de la couche métallique. A partir du multicouche, on forme également un plot de connexion supérieur 39, destiné à polariser la partie conductrice supérieure de l'antenne. On dépose ensuite une couche isolante supérieure 40, par exemple en un oxyde de silicium de type TEOS, que l'on planarise pour rendre libre la face supérieure de la couche métallique 21 de la diode ainsi que celle du plot de connexion supérieur 39.

En référence à la fig.4F, on dépose ensuite une couche isolante 41, recouvrant la couche métallique 21, le plot de connexion 39, et la couche isolante supérieure 40. Cette couche isolante 41 est réalisée en le premier isolant électrique I1 et est destinée à former la première couche isolante de la diode. Dans cet exemple, elle est réalisée en Al₂O₃ d'une épaisseur comprise entre 0.5 et 2nm, et ici de 0.5nm. Elle peut être déposée par dépôt de couche atomique (ALD) entre 200°C et 400°C environ.

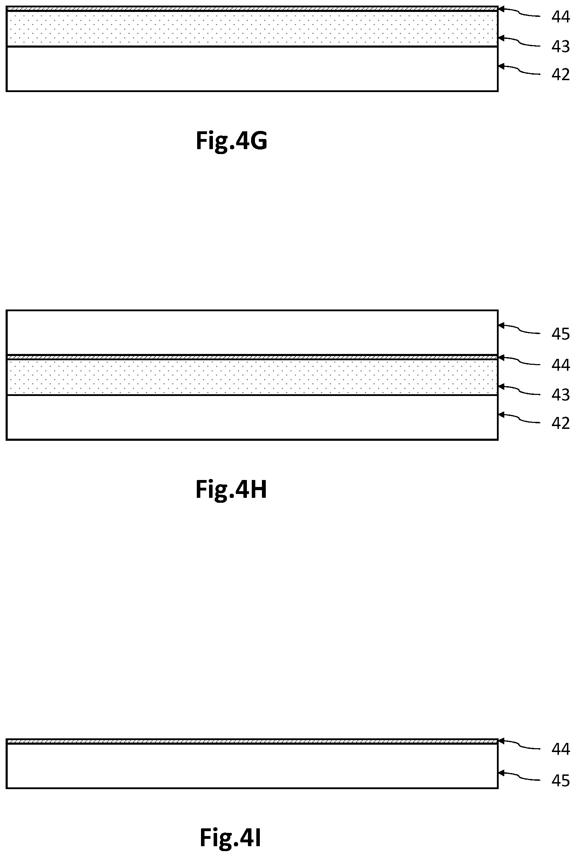

En référence à la fig.4G, on réalise une couche semiconductrice 44 de graphène, ici une couche monoatomique, sur une couche isolante 43, ici en un oxyde de silicium, reposant sur un substrat support 42. Le graphène peut être déposé initialement sur un substrat en cuivre (non représenté) par une technique de dépôt chimique en phase vapeur à haute température, par exemple à 1000°C environ, puis être transféré sur la couche d'oxyde 43.

En référence à la fig.4H, on dépose une couche 45 d'un polymère tel qu'un polyméthacrylate de méthyle (PMMA), ou une couche de colle, sur la couche semiconductrice 44 de graphène.

En référence à la fig.4I, on retire le substrat support 42 et la couche d'oxyde 43, par exemple par gravure humide de la couche d'oxyde 43 à l'acide fluorhydrique (HF) en phase vapeur. On obtient ainsi une couche 45 de PMMA sur laquelle repose la couche semiconductrice 44 de graphène. Notons que cette technique de réalisation et de transfert d'une couche de graphène est notamment décrite dans l'article de Lee et al. intitulé Multilayered Grophene Electrode using One-Step Dry Transfer for Optoelectronics, Current Optics and Photonics, Vol. 1, Issue 1, pp. 7-11 (2017).

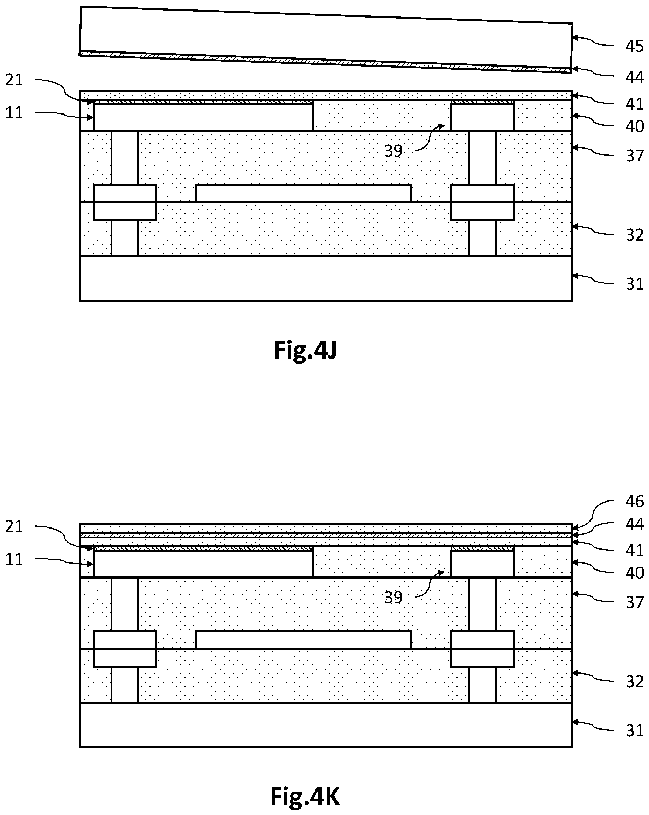

En référence à la fig.4J, on transfère la couche semiconductrice 44 de graphène sur la couche isolante 41 en Al₂O₃. La couche semiconductrice 44 de graphène est alors mise au contact de l'Al₂O₃.

En référence à la fig.4K, on retire la couche 45 de PMMA, par exemple avec un solvant de type acétone, pour rendre libre la face supérieure de la couche semiconductrice 44 de graphène. Ensuite, on dépose une couche isolante 46, recouvrant la couche semiconductrice 44 de graphène. Cette couche isolante 46 est réalisée en le deuxième isolant électrique I2 et est destinée à former la deuxième couche isolante de la diode. Dans cet exemple, elle est réalisée en HfO₂ d'une épaisseur comprise entre 0.5 et 2nm, et ici de 0.5nm. Elle peut être déposée par dépôt de couche atomique (ALD) entre 200°C et 400°C environ.

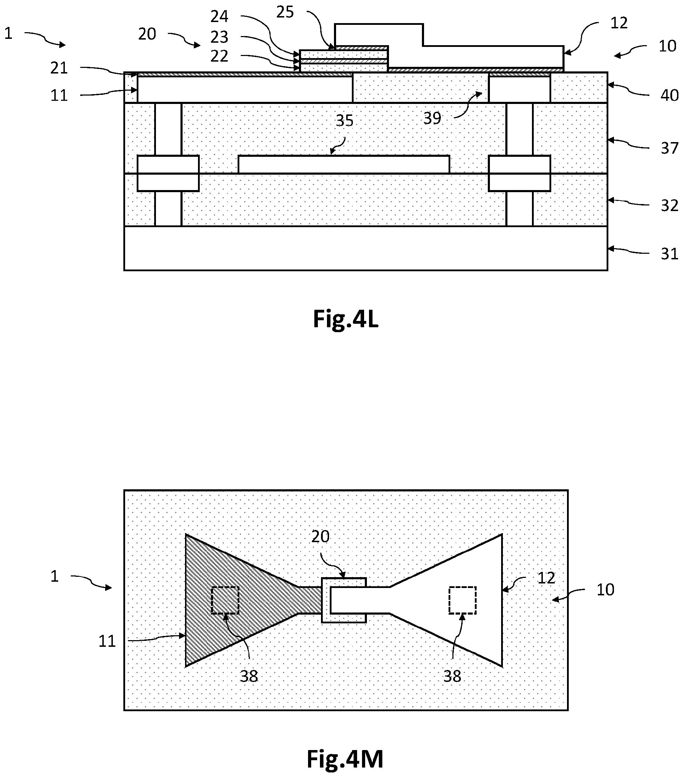

En référence à la fig.4L et à la fig.4M, on gravure localement l'empilement des couches isolantes 41, 46 et de la couche semiconductrice 44 de graphène, de manière à former la capacité 22, 23, 24 de la diode 20. L'empilement gravé peut présenter des dimensions dans le plan XY de l'ordre de 50 à 500nm de côté. Puis, on réalise la couche métallique supérieure 25 de la diode 20, ainsi que la partie conductrice supérieure 12 de l'antenne 10. Le dépôt est réalisé dans une ouverture traversante définie dans une couche de résine (non représentée). On dépose ici une couche de Ni formant le métal M2 de la couche métallique 25, par exemple d'une épaisseur d'au moins 80nm, suivi du dépôt d'Al, Au, ou Pt. On retire ensuite la couche de résine, par exemple par un solvant de type acétone. On obtient ainsi la couche métallique 25 de Ni qui est au contact d'au moins une surface de la couche isolante 24 en HfO₂ d'une part, et qui vient également au contact du plot de connexion supérieur 39. Elle est recouverte par le ou les métaux qui forment la partie conductrice supérieure 12 de l'antenne 10.

Ainsi, on obtient une rectenna 1 formée d'une antenne 10 ici de type papillon, et d'une diode MIGIM 20 située entre les deux sommets des parties conductrices triangulaires de l'antenne 10. La diode 20 est polarisée au moyen de vias conducteurs qui s'étendent entre les parties conductrices 11, 12 de l'antenne 10 et le circuit de lecture. De plus, l'antenne 10 est verticalement espacée d'un réflecteur 35, formant ainsi une cavité quart d'onde optimisant l'absorption du rayonnement LWIR. Dans la mesure où la diode MIGIM 20 contient la couche semiconductrice 23 en graphène située entre les couches isolantes 22, 24, la diode MIGIM 20 autorise la transmission des porteurs de charge par effet tunnel résonant tout en présentant des performances améliorées, en termes notamment de résistance dynamique et d'asymétrie, et donc de responsivité.

Des modes de réalisation particuliers viennent d'être décrits. Différentes variantes et modifications apparaîtront à l'homme du métier.

Ainsi, la couche semiconductrice 23 de graphène peut être polarisée électriquement par des moyens électriques dédiés, en plus de la polarisation électrique de la diode 20. La polarisation électrique de la couche semiconductrice 23 de graphène peut être appliquée de manière latérale, c'est-à-dire ici suivant l'axe Y. Une telle polarisation électrique supplémentaire peut augmenter l'asymétrie de la caractéristique I(V) de la diode 20, améliorant ainsi les performances de la rectenna 1.

Une telle polarisation électrique supplémentaire de la couche semiconductrice 23 de graphène peut être effectuée par des parties conductrices supplémentaires de l'antenne 10, s'étendant par exemple suivant l'axe Y, qui serait alors un deuxième axe principal de détection du rayonnement électromagnétique d'intérêt.

## Revendications

1. Dispositif rectificateur (1), comportant :
∘ une antenne (10), adaptée à absorber un rayonnement électromagnétique d'intérêt ;
∘ une diode (20) de type Métal-Isolant-Isolant-Métal (MIIM), couplée électriquement à l'antenne (10), comportant :
• une première couche métallique (21) et une deuxième couche métallique (25) ;
• une première couche isolante (22) réalisée en un premier isolant électrique (I1) présentant une affinité électronique φ₁, et une deuxième couche isolante (24) réalisée en un deuxième isolant électrique (I2) présentant une affinité électronique φ₂ différente de φ₁ ;
∘ **caractérisé en ce que** la diode (20) comporte une couche semiconductrice (23) en graphène (G), située entre les première et deuxième couches isolantes (22, 24),
∘ et **en ce que** la première couche métallique (21) est réalisée en un premier métal (M1) présentant un travail de sortie Ψ_{M1} inférieur ou égal au travail de sortie Ψ_{G} du graphène (G).

2. Dispositif rectificateur (1) selon la revendication 1, dans lequel la couche semiconductrice (23) de graphène est formée d'au plus deux feuilles monoatomiques.

3. Dispositif rectificateur (1) selon la revendication 1 ou 2, dans lequel les première et deuxième couches isolantes (22, 24) présentent une épaisseur comprise entre 0.5 et 2nm.

4. Dispositif rectificateur (1) selon l'une quelconque des revendications 1 à 3, dans lequel les première et deuxième couches métalliques (21, 25) présentent une épaisseur au moins égale à 80nm.

5. Dispositif rectificateur (1) selon l'une quelconque des revendications 1 à 4, dans lequel les affinités électroniques φ₁ et φ₂ des premier et deuxième isolants électriques (I1, I2) sont inférieures au travail de sortie Ψ_{G} du graphène (G).

6. Dispositif rectificateur (1) selon l'une quelconque des revendications 1 à 5, comportant une source électrique adaptée à appliquer une tension électrique de polarisation V_{D} non nulle à la diode (20).

7. Dispositif rectificateur (1) selon la revendication 6, dans lequel la source électrique est adaptée à appliquer un potentiel électrique à la première et à la deuxième couche métallique (21, 25), le potentiel électrique appliqué à la deuxième couche métallique (25) étant supérieur à celui appliqué à la première couche métallique (21).

8. Dispositif rectificateur (1) selon l'une quelconque des revendications 1 à 5, dans lequel la première couche métallique (21) présente un potentiel électrique égal à celui de la deuxième couche métallique (25).

9. Dispositif rectificateur (1) selon l'une quelconque des revendications 1 à 8, comportant un réflecteur (35) du rayonnement électromagnétique d'intérêt, situé entre un substrat support et l'antenne (10), et espacé de l'antenne (10) de manière à former une cavité quart d'onde.

10. Dispositif rectificateur (1) selon l'une quelconque des revendications 1 à 9, dans lequel l'antenne (10) est adaptée à absorber un rayonnement électromagnétique dans l'infrarouge ou le térahertz.

11. Système optoélectronique, comportant une matrice de dispositifs rectificateurs (1) selon l'une quelconque des revendications 1 à 10, identiques les uns aux autres.

12. Procédé de fabrication d'un dispositif rectificateur (1) selon l'une quelconque des revendications 1 à 10, comportant les étapes suivantes :
∘ réalisation d'une première partie conductrice (11) de l'antenne (10) ;
∘ réalisation de la première couche métallique (21) de la diode (10), en contact électrique de la première partie conductrice (11) de l'antenne (10) ;
∘ réalisation d'une première couche isolante continue (41), réalisée en le premier isolant électrique (I1), en contact électrique de la première couche métallique (21) ;
∘ réalisation d'une couche semiconductrice continue (44) de graphène, au contact de la couche isolante continue (41) ;
∘ réalisation d'une deuxième couche isolante continue (46), réalisée en le deuxième isolant électrique (I2), au contact de la couche semiconductrice continue (44) de graphène ;
∘ structuration de la première couche isolante continue (41), de la couche semiconductrice continue (44) et de la deuxième couche isolante continue (46), de manière à former la première couche isolante (22), la couche semiconductrice (23) de graphène, et la deuxième couche isolante (24) de la diode (20) ;
∘ réalisation de la deuxième couche métallique (25) de la diode (10), en contact électrique de la deuxième couche isolante (24) de la diode (20) ;
∘ réalisation d'une deuxième partie conductrice (12) de l'antenne (10), en contact électrique de la deuxième couche métallique (25) de la diode (10).
